Europäisches Patentamt

European Patent Office

Office européen des brevets

(11) Veröffentlichungsnummer: **0 170 724**
**A1**

(12) # EUROPÄISCHE PATENTANMELDUNG

(21) Anmeldenummer: **84114706.9**

(51) Int. Cl.⁴: **H 01 L 31/02, H 01 L 33/00**

(22) Anmeldetag: **04.12.84**

(30) Priorität: **15.03.84 DE 3409594**

(43) Veröffentlichungstag der Anmeldung: **12.02.86**
**Patentblatt 86/7**

(84) Benannte Vertragsstaaten: **AT CH DE FR GB IT LI NL**

(71) Anmelder: **Siemens Aktiengesellschaft, Berlin und München Wittelsbacherplatz 2, D-8000 München 2 (DE)**

(72) Erfinder: **Rohde, Volker, Dipl.-Ing., Buchenstrasse 10 a, D-8011 Forstinning (DE)**

(54) Optoelektronische Halbleiteranordnung und Verfahren zu ihrer Herstellung.

(57) Es wird eine optoelektronische Halbleiteranordnung vorgeschlagen, die als Gehäusebauform kein sonst übliches Metall-, Keramik- oder Kunststoffgehäuse besitzt, sondern ein solches in Mikropack-Bauweise. Der optisch wirksame Oberflächenbereich (2) des Halbleiterchips (1) bleibt, mit Ausnahme einer optisch durchlässigen Passivierung (6) frei von sonstigen Materialien. Die restliche Chipoberfläche, mit Ausnahme mindestens der Bereiche um die Anschlußkontakte (7) ist mit einer festen Schutzschicht (3) aus Metall, Metallegierung oder Kunststoff, vorzugsweise, Polyimid, bedeckt. Der Rand (R) der Schutzschicht (3) muß zu dem gedachten Mittelpunkt eines jeden Anschlußkontaktes (7) einen Minimalabstand (A) von 100 μm besitzen. Die Schutzschicht (3) ist 20 bis 150 μm, vorzugsweise 50 bis 80 μm dick. Die Schutzschicht (3) wird mittels Kleben, Drucken oder Spin-Coating und üblichen Strukturierungsverfahren aufgebracht. Zwischen der Chipkante (5) und dem äußeren Rand (R) der Schutzschicht (3) befindet sich zum Schutze der Anschlußkontakte (7) und der Anschlußleitungen (8) ein elektrisch isolierender Überzug (4), vorzugsweise aus Schutzlack. Der Schutzlack, Epoxidharz, Siliconlack, wird mittels einer Belackungsnadel aufgebracht. Der Überzug (4) kann aber auch in pulverisierter Form aufgebracht werden und thermisch verschmolzen werden. Die Anschlußleitungen (8) werden mittels Lötbonden oder Thermokompression vor Aufbringen des Überzuges (4) befestigt.

Siemens Aktiengesellschaft          Unser Zeichen
Berlin und München                  VPA 84 P 1 2 1 5 E

Optoelektronische Halbleiteranordnung und Verfahren zu
ihrer Herstellung

Die Erfindung betrifft eine optoelektronische Halbleiteranordnung nach dem Oberbegriff des Patentanspruches 1 und
ein Verfahren zu ihrer Herstellung nach dem Oberbegriff des
Patentanspruches 11.

Optoelektronische Halbleiteranordnungen, insbesondere
integrierte optoelektronische Halbleiterschaltkreise,
sind in der Industrie weit verbreitet. Zum Zwecke des
leichteren Handlings sowie zum Schutze vor mechanischen
und chemischen Einflüssen werden solche Halbleiteranordnungen noch durch deren Hersteller mit entsprechenden
Gehäusen versehen. Als Gehäuse werden derzeit metallische, keramische und solche aus transparenten Kunststoffen
verwendet. Metallische und keramische Gehäuse sind dabei
mindestens an den Gehäusestellen, durch die von Schaltungsteilen erzeugtes Licht abstrahlen soll, bzw. durch die
Licht auf lichtempfindliche Schaltungsteile im Inneren
der Gehäuse hindurchstrahlen soll, mit geeigneten Glassammellinsen oder Glasdeckeln versehen. Solche Halbleiterschaltkreise werden beispielsweise in "Siemens Components", 22. Jahrgang, Heft 1/84 auf Seite 44, beschrieben. Diese Gehäuseausführungen haben sich als technisch
hervorragend und einwandfrei bewährt, besitzen jedoch einen
wirtschaftlich schwerwiegenden Nachteil: optoelektronische Halbleiteranordnungen mit Metall- bzw. Keramikgehäusen sind sehr teuer. Sie kommen deshalb in den meisten
kommerziellen Anwendungsfällen aus Preisgründen nicht zum
Einsatz. Als preisgünstige Variante verwendet man deshalb

Ke 1 Hub / 13.03.1984

meist Gehäuse aus lichtdurchlässigen Kunststoffen. Der Preisvorteil solcher Halbleiteranordnungen wird jedoch durch negative technische Eigenschaften der benutzten Kunststoffe entwertet: Die optischen Eigenschaften verschlechtern sich durch natürliche Alterung und/oder durch äußere Einflüsse, wie Feuchtigkeit, Temperatur, Bestrahlung mit UV-Licht (beispielsweise enthält jedes natürliche Licht auch einen gewissen Anteil an UV-Strahlung).

Aufgabe der vorliegenden Erfindung ist es deshalb, eine optoelektronische Halbleiteranordnung zu schaffen, die sehr gute mechanische, optische und elektrische Langzeiteigenschaften besitzt und leicht zu handhaben ist. Ebenso soll ein Verfahren zu ihrer Herstellung geschaffen werden, das sehr billig ist und mit möglichst einfachen Mitteln durchführbar ist.

Diese Aufgabe wird bei einer Halbleiteranordnung der eingangs genannten Art durch die Merkmale des kennzeichnenden Teiles des Patentanspruches 1 sowie bei einem entsprechenden Verfahren zu ihrer Herstellung durch die Merkmale des kennzeichnenden Teiles des Patentanspruches 11 gelöst.

Die Erfindung löst die obengenannte Aufgabe in vorteilhafter Art und Weise. Sie ist außerdem unabhängig von allen Halbleitertechnologien und läßt sich auf den verschiedensten Anwendungsgebieten einsetzen, beispielsweise bei Kameras, Kopiergeräten, Ölbrennersteuerungen, Kraftwerken, Kraftfahrzeugen usw.

Weiterbildungen der Erfindung sind in jeweiligen Unteransprüchen gekennzeichnet.

Die Erfindung wird im folgenden anhand der Figuren 1, 2 und 3 näher erläutert. Es zeigen:

Fig. 1  eine erfindungsgemäße, optoelektronische Halbleiteranordnung in Draufsicht,

Fig. 2  einen Querschnitt durch eine erfindungsgemäße
        Halbleiteranordnung längs einer Schnittlinie II-II
        von Fig. 1, sowie

Fig. 3  eine mögliche Weiterbildung einer erfindungsgemäßen Halbleiteranordnung in Draufsicht.


Gleiche Elemente sind in den Figuren mit gleichen Bezugszeichen  versehen.


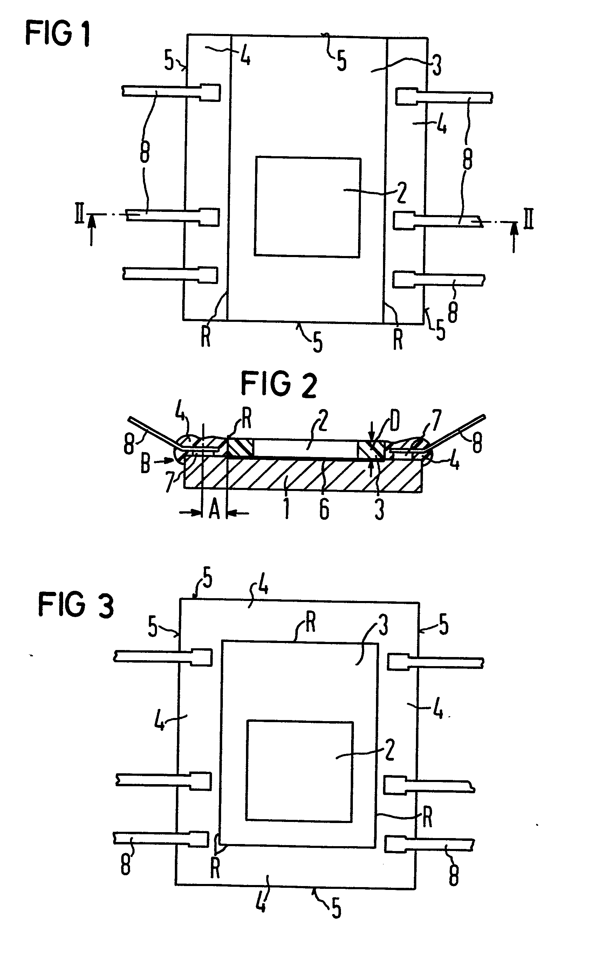

Bei einer erfindungsgemäßen optoelektronischen Halbleiteranordnung ist ein Halbleiterchip 1 in vorteilhafter Art
und Weise auf einer Mikropack-Konstruktion angeordnet. Auf
eine Darstellung der Mikropack-Konstruktion in den Figuren
wurde aus Gründen der Übersichtlichkeit verzichtet. Es
kann jede bekannte Mikropack-Konstruktion zur Anwendung
kommen. Der Halbleiterchip 1 enthält gemäß den Figuren 1
und 2 einen Oberflächenbereich 2, unterhalb dem optisch
aktive Teile einer ebenfalls nicht dargestellten Halbleiterschaltung liegen. Je nach Art der Halbleiterschaltung emittieren und/oder empfangen diese Teile Licht
eines bestimmten Wellenbereiches. Auf dem Halbleiterchip 1
befindet sich als Schutz vor chemischen und mechanischen
Einflüssen eine Passivierungsschicht 6. Sie ist zumindest
am Oberflächenbereich 2 lichtdurchlässig innerhalb des
obengenannten Wellenbereiches. Sie kann beispielsweise
Glas oder $SiO_2$ enthalten, was mit üblichen Verfahren
aufgebracht wird. Auf dem Halbleiterchip 1 werden bei der
Herstellung, wie allgemein üblich, in der Nähe einer Chipkante 5 Anschlußkontakte 7 angeordnet. An diesen entfällt
die Passivierungsschicht 6. Die Anordnung kann, je nach
Layout des Halbleiterchips 1, in der Nähe einer Kante 5,
zweier, dreier oder aller vier Kanten 5 des Halbleiterchips 1 erfolgen. Erfindungsgemäß liegt außerhalb des Oberflächenbereiches 2 eine feste Schutzschicht 3. Sie kann Metall enthalten, wie beispielsweise Kupfer, Aluminium oder Gold oder auch eine Metallegierung. Vorzugsweise jedoch enthält die Schutzschicht 3 einen Kunststoff, insbesondere Polyimid. Das Aufbringen einer metallischen Schutzschicht 3 erfolgt in üblicher Technologie durch Kleben oder Drucken, beispielsweise im Siebdruckverfahren. Verwendet man als Schutzschicht 3 Kunststoffe, z. B. Polyimide, so können diese ebenfalls durch Kleben oder Drucken, insbesondere auch im Siebdruckverfahren aufgebracht werden. Für die Verwendung von Kunststoffen bietet sich als Verfahrensschritt jedoch auch beispielsweise das allseits bekannte Spin-Coating-Verfahren ("Lackschleuder") in Verbindung mit entsprechenden Maskier- und Ätzschritten, sowie bei Verwendung photovernetzbarer Polyimide das Spin-Coating-Verfahren in Verbindung mit der bekannten Photostrukturierung (Bestrahlen) an. Nach Auftragen der Schutzschicht 3 darf diese in vorteilhafter Weise nur eine Fläche bedecken, die einerseits mit höchstens 100 $\mu$m (A) an einen gedachten Mittelpunkt jedes einzelnen Anschlußkontaktes 7 heranreicht und andererseits aber auch den Oberflächenbereich 2 freiläßt. Dieses minimale Abstandsmaß A von 100 $\mu$m ist bedingt durch den Einsatz von Werkzeugen bei einem späteren Kontaktiervorgang an den Anschlußkontakten 7. Befinden sich auf einer Seite des Halbleiterchips 1 keine Anschlußkontakte 7, so kann sich die Schutzschicht 3, wie in Fig. 1 dargestellt, bis zur entsprechenden Chipkante 5 erstrecken. Die zulässige Dicke D der Schutzschicht 3 beträgt erfindungsgemäß 20 bis 150 $\mu$m, vorzugsweise 50 bis 80 $\mu$m. Anschließend an das Aufbringen der Schutzschicht 3 werden an den Anschlußkontakten 7 Anschlußleitungen 8, beispielsweise mittels Lötbonden oder Thermokompression, befestigt. Der Teil des Halbleiterchips 1, der sich zwischen der Chipkante 5 und einem äußeren Rand R der Schutzschicht 3 befindet, d. h. also, insbesondere der Bereich um die Anschlußkontakte 7 samt einem Teil der Anschlußleitungen 8, ist mit einem Überzug 4 bedeckt. Der Überzug 4 besteht dabei, je nach Ausführung, entweder aus einem Schutzlack, beispielsweise Epoxidharz, Siliconlack, oder aus elektrisch isolierendem, zunächst pulverisierten Material. Als Aufbringungsverfahren für den Schutzlack hat sich ein Abfahren oberhalb der Chipkanten 5 mit einer sogenannten Belackungsnadel als vorteilhaft erwiesen. Dabei wird der zu schützende Bereich des Halbleiterchips 1 mit dem Schutzlack benetzt. Die Schutzschicht 3 verhindert dabei ein Verfließen des Lackes in Richtung auf den Oberflächenbereich 2. Des weiteren bewirken Adhäsionskräfte, daß sich der Schutzlack, insbesondere in der Nähe der Anschlußleitungen 8, über die Chipkante 5 hinaus an einem seitlichen Bereich B des Halbleiterchips 1 anlegt. Dadurch wird ein sonst möglicher elektrischer Kurzschluß zwischen den Anschlußleitungen 8 und dem Halbleiterchip 1 zuverlässig verhindert. Beispielsweise durch Ausheizen wird der Lack dann verfestigt. Elektrisch isolierendes, pulverisiertes Material läßt sich durch Streuen aufbringen. Anschließend wird es durch Hitzeeinwirkung zu einer physikalisch einheitlichen Schicht verschmolzen. Der Überzug 4 übernimmt erfindungsgemäß die Funktion eines Handlingschutzes der gesamten Mikropack-Anordnung sowie die eines Schutzes vor elektrischen Kurzschlüssen zwischen den Anschlußkontakten 7 bzw. daran angeschlossenen Anschlußleitungen 8 untereinander sowie zwischen den Anschlußleitungen 8 und dem Halbleiterchip 1. Auf diese Weise gelingt es einerseits, den Oberflächenbereich 2, der ja entscheidend zur optoelektrischen Funktion einer erfindungsgemäßen optoelektronischen Halbleiteranordnung beiträgt, absolut frei von irgendwelchen störenden Einflüssen oder Materialien zu halten, und andererseits in Verbindung mit der Mikropack-Gehäuseform, die Halbleiteranordnung recht billig herzustellen.

Fig. 3 zeigt eine Weiterbildung einer erfindungsgemäßen optoelektronischen Halbleiteranordnung, die genauso aufgebaut ist wie in den Figuren 1 und 2 dargestellt. Die Schutzschicht 3 erstreckt sich jedoch auf den Seiten des Halbleiterchips 1, an denen sich keine Anschlußkontakte 7 befinden, nicht bis zur jeweiligen Chipkante 5, sondern endet von allen vier Chipkanten 5 gleich weit entfernt. Das minimale Abstandsmaß A von 100 $\mu$m zwischen dem Rand R der Schutzschicht 3 und dem gedachten Mittelpunkt eines jeden Anschlußkontaktes 7 wird dabei ebenfalls nirgendwo unterschritten. Diese Ausführung der erfindungsgemäßen Halbleiteranordnung erlaubt es, die Konstruktion einer Steuerung, die einen Lackfluß aus der Belackungsnadel auf den Halbleiterchip 1 regeln soll, zu vereinfachen: gemäß Fig. 1 stellt sich aufgrund der Ausführung der Schutzschicht 3 der Überzug 4 als zwei nicht zusammenhängende, flächige Elemente dar. Für jedes dieser Elemente müssen zusätzlich zu einer Umlenkung der Belackungsnadel um 90° eine Start- und Stopbedingung für den Lackfluß erkannt und ausgeführt werden. Dies bedeutet zusätzlichen konstruktiven Aufwand gegenüber einer Ausführung nach Fig. 3. Hier ist der Überzug 4 rahmenartig ausgebildet, so daß nur eine Start- und Stopbedingung für den Lackfluß je Halbleiteranordnung konstruktiv zu berücksichtigen ist.

23 Patentansprüche
 3 Figuren

Patentansprüche

1. Optoelektronische Halbleiteranordnung
- mit einem Halbleiterchip (1), der eine optoelektronische Halbleiterschaltung enthält,
- mit einem Oberflächenbereich (2) innerhalb des Halbleiterchips (1), unterhalb dem sich lichtempfindliche, bzw. lichtemittierende Elemente der Halbleiterschaltung befinden,
- mit Anschlußkontakten (7) für die Halbleiterschaltung und an die Anschlußkontakte (7) angeschlossenen Anschlußleitungen (8),
- mit einer Passivierungsschicht (6) auf dem gesamten Halbleiterchip (1) mit Ausnahme der Anschlußkontakte (7), die optisch durchlässig ist in einem Wellenbereich, innerhalb dessen Licht emittiert bzw. empfangen wird,
- mit einem Überzug (4) auf dem Halbleiterchip (1) zum Schutze des Chips (1) und der Anschlußkontakte (7) samt einem Teilbereich der Anschlußleitungen (8) vor mechanischen, chemischen und elektrischen Einflüssen, d a d u r c h   g e k e n n z e i c h n e t , daß
- als Gehäusebauform eine Mikropack-Bauform verwendet wird,
- daß der Oberflächenbereich (2) oberhalb der Passivierungsschicht (6) frei von jeglichen Materialien ist,
- daß mindestens ein die Halbleiterschaltung enthaltender Teil des Halbleiterchips (1) ausschließlich des die lichtempfindlichen bzw. lichtemittierenden Elemente enthaltenden Oberflächenbereiches (2) und höchstens der gesamte Halbleiterchip (1) ausschließlich des die lichtempfindlichen bzw. lichtemittierenden Elemente enthaltenden Oberflächenbereiches (2) sowie ausschließlich eines Bereiches um die Anschlußkontakte (7) mit einer festen Schutzschicht (3) überzogen ist.

0170724

2. Halbleiteranordnung nach Anspruch 1,
d a d u r c h   g e k e n n z e i c h n e t ,
daß die Passivierungsschicht (6) aus Glas besteht.

3. Halbleiteranordnung nach Anspruch 1,
d a d u r c h   g e k e n n z e i c h n e t ,
daß die Passivierungsschicht (6) aus $SiO_2$ besteht.

4. Halbleiteranordnung nach einem der Ansprüche 1 bis 3,
d a d u r c h   g e k e n n z e i c h n e t ,
daß die Schutzschicht (3) eine Dicke (D) von 20 bis 150 μm
besitzt, vorzugsweise eine Dicke (D) von 50 bis 80 μm.

5. Halbleiteranordnung nach einem der Ansprüche 1 bis 4,
d a d u r c h   g e k e n n z e i c h n e t ,
daß die Schutzschicht (3) an jeder Stelle des Halbleiterchips (1) einen minimalen Abstand (A) von 100 μm von
einem gedachten Mittelpunkt eines jeden Anschlußkontaktes
(7) besitzt.

6. Halbleiteranordnung nach einem der Ansprüche 1 bis 5,
d a d u r c h   g e k e n n z e i c h n e t ,
daß die Schutzschicht (3) aus Metall oder einer Metalllegierung besteht, vorzugsweise aus Kupfer, Aluminium
oder Gold.

7. Halbleiteranordnung nach einem der Ansprüche 1 bis 5,
d a d u r c h   g e k e n n z e i c h n e t ,
daß die Schutzschicht (3) aus Kunststoff besteht, vorzugsweise aus Polyimid.

8. Halbleiteranordnung nach mindestens einem der Ansprüche
1 bis 7,   d a d u r c h   g e k e n n z e i c h n e t ,
daß der Überzug (4) die Bereiche des Halbleiterchips (1)
bedeckt, die sich zwischen der Schutzschicht (3) und einer
Chipkante (5) befinden, sowie einen Bereich (B) unterhalb der Chipkante (5), vorzugsweise nahe den Anschlußleitungen (8).

0170724

9. Halbleiteranordnung nach Anspruch 8,

d a d u r c h   g e k e n n z e i c h n e t ,

daß der Überzug (4) aus elektrisch isolierendem Material besteht.

10. Halbleiteranordnung nach Anspruch 9,

d a d u r c h   g e k e n n z e i c h n e t ,

daß das elektrisch isolierende Material Schutzlack ist, insbesondere Epoxidharz, Siliconlack.

11. Verfahren zur Herstellung einer optoelektronischen Halbleiteranordnung  gemäß mindestens einem der vorhergehenden Ansprüche,

d a d u r c h   g e k e n n z e i c h n e t ,   daß

- auf den Halbleiterchip (1) mit der optoelektronischen Halbleiterschaltung anschließend an ein Aufbringen der Passivierungsschicht (6) die feste Schutzschicht (3) so aufgebracht wird, daß mindestens ein die Halbleiterschaltung enthaltender Teil des Halbleiterchips (1) ausschließlich des die lichtempfindlichen bzw. lichtemittierenden Elemente enthaltenden Oberflächenbereiches (2) und höchstens der gesamte Halbleiterchip (1) ausschließlich des die lichtempfindlichen bzw. lichtemittierenden Elemente enthaltenden Oberflächenbereiches (2) sowie ausschließlich eines Bereiches um die Anschlußkontakte (7) bedeckt ist,

- anschließend Anschlußleitungen (8) an den Anschlußkontakten (7) befestigt werden und daran

- anschließend auf einen von der Schutzschicht (3) nicht bedeckten Bereich der Chipoberfläche mit Ausnahme des die lichtempfindlichen bzw. lichtemittierenden Elemente enthaltenden Oberflächenbereiches (2) ein Überzug (4) aus elektrisch isolierendem Material aufgetragen wird, so daß sowohl der Halbleiterchip (1) als auch die Anschlußkontakte (7) samt einem Teil ihrer Anschlußleitungen (8) vor mechanischen, chemischen und elektrischen Einflüssen geschützt sind.

12. Verfahren nach Anspruch 11,
d a d u r c h   g e k e n n z e i c h n e t ,
daß als Schutzschicht (3) Metalle, Metallegierungen oder Kunststoffe, insbesondere Polyimide, verwendet werden.

13. Verfahren nach Anspruch 11 oder 12,
d a d u r c h   g e k e n n z e i c h n e t ,
daß die Schutzschicht (3) aufgedruckt wird.

14. Verfahren nach Anspruch 13,
d a d u r c h   g e k e n n z e i c h n e t ,
daß als Druckverfahren das Siebdruckverfahren verwendet wird.

15. Verfahren nach Anspruch 11 oder 12,
d a d u r c h   g e k e n n z e i c h n e t ,
daß die Schutzschicht (3) aufgeklebt wird.

16. Verfahren nach Anspruch 11 oder 12,
d a d u r c h   g e k e n n z e i c h n e t ,
daß bei Verwendung von Polyimiden als Schutzschicht (3) diese mittels Spin-Coating-Verfahren in Verbindung mit Strukturierungsschritten (Photomaskieren, Ätzen) aufgebracht werden.

17. Verfahren nach Anspruch 11 oder 12,
d a d u r c h   g e k e n n z e i c h n e t ,
daß bei Verwendung photovernetzbarer Polyimide als Schutzschicht (3) diese mittels Spin-Coating-Verfahren aufgebracht werden und durch Bestrahlen photostrukturiert werden.

0170724

18. Verfahren nach mindestens einem der Ansprüche 11 bis 17,
d a d u r c h   g e k e n n z e i c h n e t ,
daß das Auftragen der Schutzschicht (3) so erfolgt, daß
sie danach eine Dicke (D) von 20 bis 150 $\mu$m besitzt, vorzugsweise eine solche von 50 bis 80 $\mu$m.

19. Verfahren nach mindestens einem der Ansprüche 11 bis 18,
d a d u r c h   g e k e n n z e i c h n e t ,
daß die Schutzschicht (3) so aufgetragen wird, daß ihr
Rand (R) danach an jeder Stelle des Halbleiterchips (1)
von einem gedachten Mittelpunkt eines jeden Anschlußkontaktes (7) einen minimalen Abstand (A) von 100 $\mu$m besitzt.

20. Verfahren nach mindestens einem der Ansprüche 11 bis 19,
d a d u r c h   g e k e n n z e i c h n e t ,
daß die Anschlußleitungen (8) auf die Anschlußkontakte (7)
mittels Lötbonden befestigt werden.

21. Verfahren nach mindestens einem der Ansprüche 11 bis 19,
d a d u r c h   g e k e n n z e i c h n e t ,
daß die Anschlußleitungen (8) auf den Anschlußkontakten
(7) mittels Thermokompression befestigt werden.

22. Verfahren nach mindestens einem der Ansprüche 11 bis 21,
d a d u r c h   g e k e n n z e i c h n e t ,
daß als Überzug (4) elektrisch isolierendes Material in
pulverisierter Form verwendet wird, das nach Aufstreuen
durch Hitzeeinwirkung zu einer physikalisch einheitlichen
Schicht verschmolzen wird.

23. Verfahren nach mindestens einem der Ansprüche 11 bis 21,
d a d u r c h   g e k e n n z e i c h n e t ,
daß als Überzug (4) Schutzlack, vorzugsweise Epoxidharz,
Siliconlack, verwendet wird, der mit Hilfe einer Belackungsnadel aufgetragen wird, indem die Chipkanten (5) mit der Belackungsnadel abgefahren werden, wobei der mit dem Überzug (4) zu bedeckende Bereich mit dem Schutzlack benetzt
wird, und wobei die Schutzschicht (3) ein Verfließen des
Lackes in Richtung auf den die lichtempfindlichen bzw.
lichtemittierenden Elemente enthaltenden Oberflächenbereich (2) verhindert, und wobei auftretende Adhäsionskräfte insbesondere in der Nähe der Anschlußleitungen (8)
bewirken, daß sich der Schutzlack zusätzlich an einem
seitlichen Bereich (B) des Halbleiterchips (1) anlegt.

FIG 1

FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | IBM TECHNICAL DISCLOSURE BULLETIN, Band 17, Nr. 3, August 1974, Seiten 935-936, New York, US; D.E. EISENMANN u.a.: "Polymer field stop for electrooptic device" * Insgesamt * | 1,4,7, 11,12, 16,18 | H 01 L 31/02 H 01 L 33/00 |
| | --- | | |
| Y | DE-A-3 019 868 (HITACHI LTD.) * Seiten 4-7; Abbildungen 1a-1d * | 1,3,4, 7-9,11 ,12,18 ,20 | |
| | --- | | |
| A | DE-A-3 129 967 (SIEMENS AG) * Insgesamt * | 1,3,6, 11 | |
| | --- | | **RECHERCHIERTE SACHGEBIETE (Int. Cl.4)** |
| A | US-A-3 777 365 (C.W. UMBAUGH) * Insgesamt * | 1,11, 21 | H 01 L |
| | --- | | |
| A | DE-A-2 946 801 (HITACHI LTD.) * Anspruch 1; Seite 11; Seite 12, Zeile 31 - Seite 13, Zeile 15; Abbildungen 2a,5a,6 * | 1,4,7- 9,11, 12 | |
| | --- | | |
| A | US-A-4 249 967 (YET. ZEN LIU u.a.) | | |
| | --- -/- | | |

Der vorliegende Recherchenbericht wurde für alle Patentansprüche erstellt.

| Recherchenort | Abschlußdatum der Recherche | Prüfer |
|---|---|---|
| DEN HAAG | 13-05-1985 | VISENTIN A. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82

**Europäisches Patentamt**

0170724

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | PATENTS ABSTRACTS OF JAPAN, Band 4, Nr. 181 (E-37)[663], 13. Dezember 1980; & JP - A - 55 124 277 (NIPPON DENKI K.K.) 25.09.1980 ----- | | |

RECHERCHIERTE SACHGEBIETE (Int. Cl.4)

Der vorliegende Recherchenbericht wurde für alle Patentansprüche erstellt.

| Recherchenort DEN HAAG | Abschlußdatum der Recherche 13-05-1985 | Prüfer VISENTIN A. |
|---|---|---|